(19) Europäisches Patentamt
European Patent Office
Office européen des brevets

(11) **EP 1 352 417 B1**

(12) **EUROPÄISCHE PATENTSCHRIFT**

(45) Veröffentlichungstag und Bekanntmachung des Hinweises auf die Patenterteilung:
**28.03.2007 Patentblatt 2007/13**

(21) Anmeldenummer: **02708154.6**

(22) Anmeldetag: **16.01.2002**

(51) Int Cl.:
***H01L 21/00*** *(2006.01)*

(86) Internationale Anmeldenummer:
**PCT/DE2002/000170**

(87) Internationale Veröffentlichungsnummer:
**WO 2002/056338 (18.07.2002 Gazette 2002/29)**

(54) **VORRICHTUNG ZUR PLASMAGESTÜTZTEN BEARBEITUNG VON OBERFLÄCHEN PLANARER SUBSTRATE**

DEVICE FOR THE PLASMA-MEDIATED WORKING OF SURFACES ON PLANAR SUBSTRATES

DISPOSITIF DE TRAITEMENT ASSISTE PAR PLASMA DE SURFACES DE SUBSTRATS PLANS

(84) Benannte Vertragsstaaten:
**AT BE CH CY DE DK ES FI FR GB GR IE IT LI LU MC NL PT SE TR**

(30) Priorität: **16.01.2001 DE 10102677**

(43) Veröffentlichungstag der Anmeldung:
**15.10.2003 Patentblatt 2003/42**

(73) Patentinhaber: **Forschungs- und Applikationslabor Plasmatechnik GmbH Dresden
01217 Dresden (DE)**

(72) Erfinder:
• **KUSKE, Jürgen
01239 Dresden (DE)**

• **STEPHAN, Ulf
01309 Dresden (DE)**
• **KOTTWITZ, Alfred
01774 Höckendorf (DE)**
• **SCHADE, Klaus
01468 Moritzburg-Boxdorf (DE)**

(74) Vertreter: **Pfenning, Meinig & Partner GbR Patent- und Rechtsanwälte
Gostritzer Strasse 61-63
01217 Dresden (DE)**

(56) Entgegenhaltungen:
**WO-A-99/39385          DE-A- 4 301 189
DE-C- 4 109 619**

**Beschreibung**

Die Erfindung betrifft eine Vorrichtung nach dem Oberbegriff des Anspruchs 1, wobei die Bearbeitung entsprechender Substratoberflächen mittels Plasma, das durch Niederdruckgasentladungen im HF-/VHF-Bereich erhalten worden ist, erfolgt. Eine solche Bearbeitung kann beispielsweise eine Modifizierung der Oberfläche sein, wie dies beispielsweise beim sogenannten Trockenätzen der Fall ist. Es können aber auch dünne Schichten auf Substratoberflächen abgeschieden werden. Besonders geeignet ist die erfindungsgemäße Vorrichtung zum Beschichten unterschiedlichster Substrate mit amorphem Silicium in reiner, bzw. auch dotierter Form, so dass Halbleiterschichtsysteme, die ganz besonders vorteilhaft in der Photovoltaik eingesetzt werden können, herstellbar sind.

Bekanntermaßen kann die Effektivität, z.B. die Erhöhung der Abscheiderate, durch Erhöhung der an die zur Erzeugung des Plasmas eingesetzten Elektroden angelegten Frequenzen ebenfalls erhöht werden.

Eine solche Erhöhung der Abscheiderate ist insbesondere dann von Bedeutung, wenn großflächige Substrate, wie z.B. Solarzellen mit geeigneten Schichten bzw. Schichtsystemen versehen werden sollen. Die für die Beschichtung bzw. Bearbeitung dieser Oberflächen gewünschten hohen Bearbeitungsgeschwindigkeiten erfordern hohe Plasmadichten, die jedoch nur mit entsprechend hohen Frequenzen erreichbar sind. Es ist daher wünschenswert, die Frequenzen in den VHF-Bereich zu verlegen, der bevorzugt oberhalb 30 MHz liegen sollte, zu legen.

Bei der Modifizierung bzw. bei der Beschichtung gro-ßer Substratflächen treten aber auch entsprechend große elektrische Kapazitäten des Elektrodensystems, auf. Durch die an sich bekannte Ausbildung stehender Wellen und Hohlleiterwellen auf den Elektroden kommt es zu einer inhomogenen Oberflächenbehandlung und die zu beschichtende bzw. zu bearbeitende Substratoberfläche ist deshalb entsprechend begrenzt.

Es ist weiter bekannt, dass die Impedanz des Elektrodensystems mit sich vergrößernder Elektrodenfläche stark kapazitiv und niedrigohmig wird, so dass höhere Blindströme und demzufolge Leitungsverluste und niedrigere Spannungen an der Elektrode zu verzeichnen sind. Insbesondere die Spannungserniedrigung beeinträchtigt das Zündverhalten der Niedrigdruckgasentladung, was zur Verringerung der Effektivität führt. Dieser Effekt wird mit steigender Frequenz für den Prozeß zunehmend ungünstiger. Bisher mussten bei der Bearbeitung von großflächigen Substratflächen daher entsprechende Kompromisse eingegangen werden, wobei entweder die jeweilige zu bearbeitende Fläche oder die eingesetzte Frequenz entsprechend reduziert werden mussten, so dass der Bearbeitungskapazität Grenzen gesetzt sind.

So ist in EP 0 576 559 B1 eine Beschichtungsvorrichtung beschrieben, mit der für die Photovoltaik geeignete Schichtsysteme auf Siliciumbasis auf Substrate aufgebracht werden können.

Bei dieser bekannten Vorrichtung sind jedoch die eingangs genannten Probleme, die im VHF-Bereich auftreten, unberücksichtigt geblieben und es wird lediglich ein Auftrag entsprechender Schichten auf eine Substratmaterialbahn durch mehrere nacheinander angeordnete Beschichtungskammern beschrieben, in denen unterschiedliche Schichten ausgebildet bzw. Modifizierungen von bereits ausgebildeten Schichten und insbesondere die Entfernung von Verunreinigungen an solchen Schichten durch Verwendung entsprechend geeigneter Prozeßgase in den einzelnen Beschichtungskammern durchgeführt werden.

Außerdem ist der dort beschriebene Aufbau der Beschichtungsvorrichtung sehr aufwendig, da neben der als Kathode fungierenden einen Elektrode zusätzliche Plasma erzeugende Elemente, die bevorzugt stabförmig ausgebildet sind, eingesetzt werden sollen. Dabei sind in den verschiedensten Beschichtungskammern in Transportrichtung des Substratmaterials vor und hinter der Kathode jeweils eine solche Plasma erzeugende Einheit angeordnet, die außerdem mit von der Kathode abweichender Frequenz betrieben werden sollen, so dass eine gegenseitige Beeinflussung des Plasma von den unterschiedlichen Quellen nicht ausgeschlossen werden kann.

Des weiteren ist in DE 43 01 189 C2 eine Vorrichtung zum Beschichten von Substraten bekannt, bei der in einer Prozeßkammer eine planare Elektrode für eine hochfrequenzplasmachemische Behandlung von planaren Substraten vorhanden sind.

Dabei werden eine oberhalb eines zu behandelnden Substrates, das auf einem Substratträger angeordnet sein kann, die Elektrode umschließende topfförmige Dunkelraumabschirmung und auf der Unterseite des Substrates eine in Scheibenform ausgebildete zweite Dunkelraumabschirmung eingesetzt. Die beiden voneinander getrennten Dunkelraumabschirmungen sind über die Wände der Prozeßkammern an Erdpotential angeschlossen.

Mittels dieser zweiteiligen Dunkelraumabschirmungen sollen durch eine geeignete Dimensionierung und die Einhaltung bestimmter Abstände eine parasitäre Plasmabildung verhindert werden.

Es ist daher Aufgabe der Erfindung, eine kostengünstige Vorrichtung vorzuschlagen, mit der relativ großformatige Substratoberflächen bei erhöhter Frequenz, bevorzugt im Frequenzbereich oberhalb 30 MHz, bearbeitet werden können.

Erfindungsgemäß wird diese Aufgabe mit einer Vorrichtung, die die Merkmale des Anspruchs 1 aufweist, gelöst. Vorteilhafte Ausgestaltungsformen und Weiterbildungen der Erfindung, können mit den in den untergeordneten Ansprüchen genannten Merkmalen erreicht werden.

Die erfindungsgemäße Vorrichtung verwendet eine Kammer, die auch eine Vakuumkammer sein kann, wie sie an sich bekannt ist, d.h., dass eine entsprechend unterdruckerzeugende Einrichtung (Vakuumpumpe) angeschlossen ist. Der Anschluss einer solchen Einrichtung kann auch unmittelbar an einem Massetunnel erfolgen. Au-ßerdem sind Anschlüsse für die Zu- und Abführung von Prozeßgasen vorhanden und es wird ein HF/VHF-Frequenzgenerator, der an mindestens eine Elektrode, mit der durch Niederdruckgasentladung Plasma erzeugt werden kann, eingesetzt. In ebenfalls an sich bekannter Weise kann auch eine so genannte Anpassungseinheit vorhanden sein, mit der dem Problem der Ausbildung stehender Wellen auf dem Leistungssystem zwischen Generator und Anpassung entgegengewirkt werden kann.

Erfindungsgemäß ist in einer solchen Kammer mindestens ein Massetunnel angeordnet. In diesem Massetunnel ist ein im Wesentlichen gegenüber dem Kammervolumen abgeschlossener Entladungsraum ausgebildet. In diesem Entladungsraum ist eine HF/VHF-Elektrode in einem geringeren Abstand und parallel zur jeweiligen Substratoberfläche angeordnet, so dass das erzeugte Plasma vorrangig zwischen Elektrode und Substratoberfläche ausgebildet ist. Dieser Abstand kann dem jeweiligen Bearbeitungsprozeß entsprechend angepaßt werden.

Im Massetunnel sind ebenfalls sich zwei diametral gegenüberliegend angeordnete Schlitze ausgebildet, deren Breite und Höhe entsprechend dem zu bearbeitenden Substrat bzw. einem Substrat mit einem Substratträger gewählt worden sind. Das Substrat bzw. das Substrat mit einem Substratträger können durch diese Schlitze durch den Massetunnel und demzufolge auch durch den Entladungsraum translatorisch bewegt werden. Der Massetunnel ist bis auf diese Schlitze allseitig geschlossen.

Während der Bearbeitung sind diese Schlitze, bei in den Massetunnel eingeführtem Substrat bzw. Substratträger mit Substrat bis auf kleine Spalte ausgefüllt und so ist der Massetunnel gegenüber seiner Umgebung abgeschlossen.

Durch den Massetunnel ist eine Prozeßgaszuführung in den Entladungsraum und eine Prozeßgasabführung aus dem Entladungsraum geführt. Dabei soll gesichert sein, dass innerhalb des Entladungsraumes zumindest während der Zeit, in der eine Bearbeitung einer Substratoberfläche erfolgt, eine Druckdifferenz zum übrigen Kammervolumen eingehalten ist. Der Druck im Entladungsraum sollte während eines Beschichtungsprozesses größer und beim Trockenätzen kleiner sein, wobei der Druck vorteilhaft mindestens um das 50-fache größer oder kleiner, als der Druck im übrigen Volumen der Vakuumkammer sein soll.

Dies kann durch Einstellung der Prozeßgasströme erreicht werden und wird durch geeignete an die Dimension der zu bearbeitenden Substrate bzw. des Substrates mit Substratträger angepaßter Dimensionierung der freien Querschnitte der Schlitze mit kleinen Spaltmaßen erreicht. Diese Maßnahmen sichern auch, dass nahezu keine Prozeßgase aus dem Entladungsraum in den übrigen Bereich der Kammer entweichen können und bilden einen gasdichten Abschluss. Die Schlitze wirken in Verbindung mit dem Substrat oder Substratträger, das bzw. der die Schlitze während der Bearbeitung teilweise, bevorzugt zum größten Teil verschließen, als Drosselstellen für die Gasströmung, so dass die jeweils erforderliche Druckdifferenz zwischen Entladungsraum und dem übrigen Kammervolumen eingehalten werden kann. Bereiche des Substrates oder Substratträgers sind während des Bearbeitungsprozesses innerhalb der beiden Schlitze angeordnet.

Die Bearbeitung der Substrate kann dabei so erfolgen, dass ein entsprechend geeignetes Substrat, beispielsweise eine Folie kontinuierlich mit vorgebbarer Geschwindigkeit durch die Schlitze und den Entladungsraum transportiert und dabei die Bearbeitung der Oberfläche kontinuierlich durchgeführt wird.

Es besteht aber auch die Möglichkeit, einzelne planare, flächige Substrate durch die Schlitze in den Massetunnel einzuführen, im Entladungsraum zu positionieren, über einen vorgebbaren Zeitraum zu bearbeiten und im Anschluß daran, durch den nachfolgenden Schlitz aus dem Massetunnel zu entfernen. In diesem Fall kann es vorteilhaft sein, ein solches Substrat auf einem Substratträger zu positionieren und beide gemeinsam in bzw. durch den Massetunnel für die Bearbeitung zu führen. Dabei können vorteilhaft entsprechend ausgebildete Aufnahmen in einem Substratträger ausgebildet sein, in den ein ebenes, flächiges Substrat eingelegt werden kann, so dass bei eingelegtem Substrat Substratträger und Substratoberfläche fluchten.

In beiden beschriebenen Fällen sollte die Breite der HF/VHF-Elektrode gemessen, zur Bewegungsrichtung des Substrates orthogonal größer als die entsprechende Breite des Substrates sein, so dass eine homogene, vollflächige Bearbeitung erreicht werden kann.

Die Leistungsverluste sowie Wartung und Reparatur der erfindungsgemäßen Vorrichtung können insbesondere dadurch verringert werden, dass die HF/VHF-Elektrode ein elektrisch isoliert und vakuumdicht in die Kammerwand der Kammer und in den Massetunnel einsetzbares Teil ist, das demzufolge leicht entfernt und ausgetauscht werden kann.

Der Massetunnel ist aus einem elektrisch leitenden Material, z.B. eine Aluminiumlegierung gebildet, was aus Kostengründen und insbesondere für die Bearbeitung von Substraten, bei denen eine Erwärmung auf Temperaturen, die bis oberhalb 200 °C liegen, günstig ist.

An der äußeren Oberfläche des Massetunnels können Heizelemente, die beispielsweise widerstandsbeheizt werden können, angeordnet werden. Es besteht aber auch die Möglichkeit, solche Heizelemente in den Massetunnel einzubetten.

Die Stromzuführung vom Frequenzgenerator zur HF/VHF-Elektrode kann vorteilhaft als Ein- oder besonders vorteilhaft Mehrfacheinspeisung orthogonal zur Substratoberfläche ausgebildet sein, um besonders günstige Verhältnisse zur Zündung der Niederdruckgasentladung und Ausbildung eines relativ homogenen Plasmas zu sichern.

Die Ankopplung des elektrischen Stromes sollte vorteilhaft nicht direkt, sondern zwischen Substrat oder Substrat mit Substratträger und Massetunnel auf kapazitivem Wege erfolgen, wobei bei Verwendung eines elektrisch leitenden Substratträgers dieser galvanisch isoliert und über die gesamte Fläche des Substratträgers, auf der dem Entladungsraum abgewandten Seite kapazitiv geerdet sein.

Vorteilhaft ist es außerdem, das Prozeßgas durch den Entladungsraum von der entsprechend angeordneten Prozeßgaszuführung zur Prozeßgasabführung parallel zur zu bearbeitenden Substratoberfläche und vorteilhaft möglichst auch in Transportrichtung des Substrates zu führen. Dies kann mittels einer Gasdusche, die an der Seite des Entladungsraumes an der der Schlitz durch den das Substrat ein- oder herausgeführt und mittels einer Mehrfachschlitzblende, die an der Seite an der der Schlitz durch den das Substrat aus dem Entladungsraum heraus- oder eingeführt wird, angeordnet sind, vollflächig erfolgen.

Die bereits mehrfach erwähnten und im Massetunnel ausgebildeten Schlitze sollten zur Sicherung einer guten Abdichtung zwischen dem Entladungsraum, in dem ein höherer oder niedrigerer Druck eingestellt worden ist und dem übrigen Kammervolumen der Vakuumkammer in Bewegungsrichtung der Substrate, relativ lang sein, wobei sie eine Länge von mindestens 40 mm aufweisen sollten, so dass sie in Verbindung mit dem entsprechend der Substratdimension ausgebildeten freien Querschnitt einen hohen Strömungswiderstand darstellen, der eine dynamische Schleuse bildend, dem unerwünschten Austritt von Prozeßgas aus dem Entladungsraum in das Kammervolumen der Vakuumkammer und umgekehrt stark behindern kann.

Die Abstände zwischen den Innenwänden der Schlitze und dem Substrat bzw. dem Substrat mit dem gegebenenfalls zusätzlich eingesetzten Substratträgern sollten in alle Richtungen möglichst kleine freie Spaltmaße aufweisen.

Eine erfindungsgemäße Vorrichtung kann aber auch in einer Kammer mit einem gemeinsamen Massetunnel mehrere solcher HF/VHF-Elektroden mit Entladungsräumen, Gasein- und Auslässen sowie Schlitzen beinhalten, die bevorzugt in einer Reihenanordnung angeordnet sind und durch die die Substrate sukzessive bewegt und in verschiedenster Form mit unterschiedlichen Prozeßgasen bearbeitet werden können. So können Oberflächenmodifizierungen und die Ausbildung von unterschiedlichen Schichten in alternierender Form mit den nacheinander angeordneten erfindungsgemäß zu verwendenden Elementen VHF-Elektrode und Massetunnel durchgeführt werden, so dass die Bearbeitungskosten und Bearbeitungszeiten erheblich reduziert werden können.

Die, wie bereits erklärt, relativ einfach aufgebaute und kostengünstig herstellbare erfindungsgemäße Vorrichtung ermöglicht es, eine Bearbeitung an relativ großflächigen Substratoberflächen von ca. 0,75 m² und größer auch bei eingesetzten Frequenzen oberhalb 40 MHz in homogener Form durchzuführen. Sowohl die Stromzuführung, wie auch die Stromableitung orthogonal zur Substratoberfläche, ohne die Verwendung verschleißbehafteter Schleifkontakte führen in Verbindung mit dem erreichbaren homogenen Prozeßgasangebot zu einer homogenen Bearbeitung der gewünschten großen Oberflächen.

Insbesondere bei der Anordnung von mehreren Elektroden mit Massetunneln in Reihenanordnung kann eine gleiche mittlere Verweilzeit aller Prozeßgasteilströme eingehalten werden.

Verunreinigungen der entsprechend verwendeten Prozeßgase, insbesondere durch Restgase, können nahezu vollständig vermieden werden.

Nachfolgend soll die Erfindung beispielhaft näher erläutert werden.

Dabei zeigen:

Figur 1    in einem Teilschnitt, den schematischen Aufbau eines Beispiels einer erfindungsgemäßen Vorrichtung und

Figur 2    eine schematische Schnittärstellung in einer anderen Ansicht.

In einer Vakuumkammer, deren obere und untere Kammerwände 11, 11' schematisch angedeutet sind, ist in der oberen Kammerwand 11' eine Öffnung ausgebildet, in die eine HF/VHF-Elektrode 9 vakuumdicht und elektrisch isoliert eingesetzt worden ist. Zwischen Kammerwand 11' und HF/VHF-Elektrode 9 ist ein Isolator 13 angeordnet. Es sind weiterhin schematisch eine orthogonale, hier Einfachspeisung der Hochfrequenz an die HF/VHF-Elektrode 9, ausgehend von einem Frequenzgenerator 12 eingezeichnet, die bei diesem Beispiel eine Frequenz von 40,68 MHz zuführt.

In der Vakuumkammer ist außerdem ein Massetunnel 3, der bei diesem Beispiel im Wesentlichen aus Aluminium besteht, angeordnet. Im Massetunnel 3 ist der Entladungsraum 6 ausgebildet, in dem durch Niederdruckgasentladungen ein Plasma eines in den Entladungsraum 6 zuführbaren Prozeßgases erzeugt werden kann, das zur plasmachemischen Bearbeitung bzw. auch zur Ausbildung einer Schicht auf einem Substrat 1 genutzt werden kann.

Als Prozeßgas können einschlägig bekannte Gase bzw. Gasgemische, wie z.B. $SiH_4/H_2$ benutzt werden.

An den äußeren Oberflächen des Massetunnels 3 sind eine Vielzahl von Heizelementen 10 angeordnet, mit denen die Temperatur während der plasmachemischen Bearbeitung eingestellt werden kann, um die Qualität ausgebildeter Schichten positiv beeinflussen zu können. Die Heizelemente 10 können in relativ einfacher Form widerstandsbeheizt sein. Vorteilhaft kann eine Temperierung unter Verwendung mindestens eines Temperatursensors erfolgen.

Im Massetunnel 3 sind sich diametral gegenüberliegend angeordnete Schlitze 4 und 5 ausgebildet, durch die ein Substrat 1 allein, aber auch, wie bei diesem Beispiel, gemeinsam mit einem Substratträger 2 in den Entladungsraum 6 translatorisch bewegt und durch den Schlitz 5 aus diesem wieder entfernt werden kann.

Die Schlitze 4 und 5 sind mit ihren freien Querschnitten entsprechend der Querschnittsfläche von Substrat 1 bzw. Substrat 1 mit Substratträger 2 dimensioniert, so dass eine problemlose translatorische Bewegung durch die Schlitze 4 und 5, aber auch durch den sehr kleinen freien Spalt ein großer Strömungswiderstand für in den Entladungsraum 6 geführtes oder aus dem Entladungsraum 6 austretendes Prozeßgas gesichert werden kann. Dies ist erforderlich, um das Prozeßgas am Entweichen aus dem Entladungsraum 6 zu hindern. Im Entladungsraum 6 kann bei Beschichtungsprozessen ein Druck von 50 Pa eingestellt werden, der über dem Druck in der Vakuumkammer liegt und diesen 50-fach übersteigt.

Die Schlitze 4 und 5 haben bei diesem Beispiel eine Spalthöhe von 0,5 mm.

Bevorzugt sind in den Schlitzen 4 und 5 Rollen oder Walzen eingelassen, um den Reibungswiderstand bei der translatorischen Bewegung des Substrates 1 bzw. des Substratträgers 2 entsprechend zu verringern.

Im Substratträger 2 ist in Richtung auf die Elektrode 9 eine offene Aufnahme für mindestens ein Substrat 1, in die ein solches Substrat möglichst paßgenau eingesetzt werden kann, ausgebildet.

Im Gegensatz zur dargestellten Ausbildung eines solchen Substratträgers 2 kann eine solche Aufnahme auch so ausgebildet sein, dass ein Entladungsraum 6 zwischen Elektrode 9 und dem in die Aufnahme des Substratträgers 2 eingesetzten Substrates 1 zumindest teilweise innerhalb des Substratträgers 2 ausgebildet ist.

Man kann so einen Massetunnel 3 mit durch die Schlitze 4 und 5 eingeführtem Substratträger 2, in dem ein Substrat 1 zur plasmachemischen Behandlung aufgenommen ist, mit einer Streichholzschachtel vergleichen, wobei selbstverständlich die Anordnung der Elektrode 9 zu berücksichtigen ist und auch die Dimensionierung der Spaltmaße innerhalb der Schlitze 4, 5 unter Berücksichtigung der Substratträger 2, der jeweiligen Länge der Schlitze 4 und 5 in Bewegungsrichtung der Substratträger 2 zur Erzielung der gewünschten Gasdichtheit beachtet werden sollten.

An der Seite, an der der Schlitz 5 in den Entladungsraum 6 mündet, ist eine Prozeßgaszuführung 7 über eine Lochblende ausgebildet und auf der gegenüberliegenden Seite des Entladungsraumes 6 ist eine Prozeßgasabführung in Form einer Mehrfachschlitzblende 8 angeordnet. Das Prozeßgas wird demzufolge parallel und im Gegenstrom zur Transportrichtung des Substrates 1 durch den Entladungsraum 6 geführt.

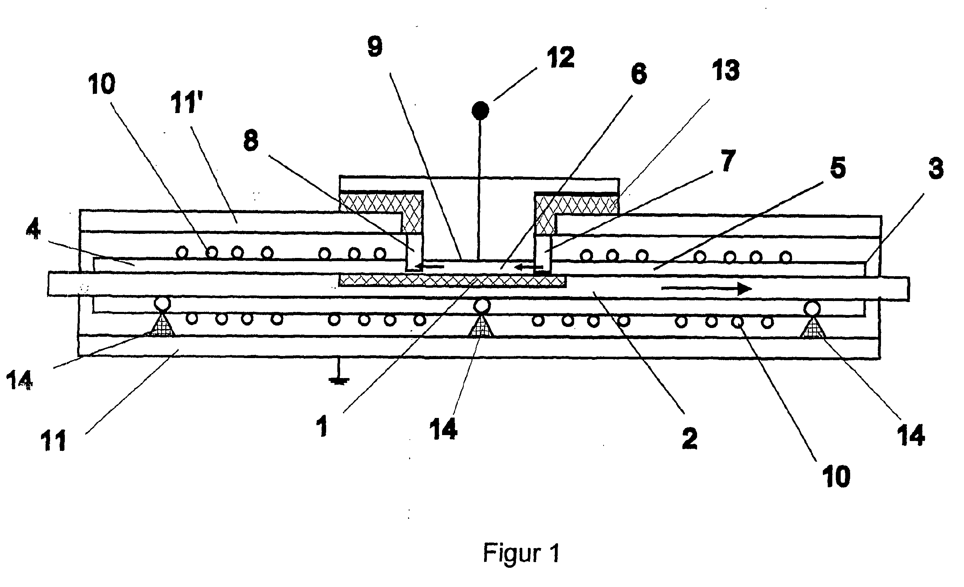

Es ist in Figur 1 ebenfalls schematisch angedeutet, dass der Massetunnel 3 mittels Isolatoren 13 und 14 gegenüber der Kammerwände 11, 11' elektrisch isoliert ist.

Die Stromzuführung kann kapazitiv vom Substrat 1 über Substratträger 2 zum Massetunnel 3 mit der unteren Kammerwand 11 möglichst vollflächig über die gesamte Fläche des Substrates 1 erfolgen, wie dies ebenfalls schematisch in der Figur 1 angedeutet worden ist.

Desweiteren ist mit den beiden Pfeilen schematisch angedeutet, wie eine Druckdifferenz zwischen Entladungsraum 6 und dem übrigen Vakuumkammervolumen je nach Prozeß auch durch Druckabsenkung bzw. Druckerhöhung (bevorzugt Zufuhr eines inerten Gases) eingestellt werden kann.

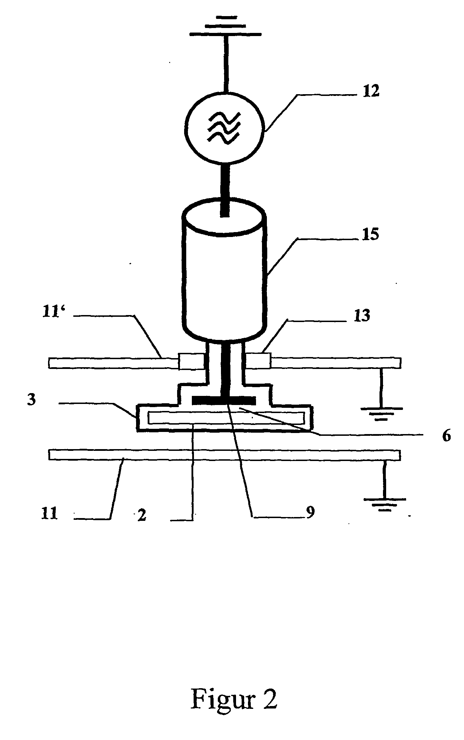

Mit Figur 2 soll in einer schematischen Darstellung in einer anderen Ansicht, die orthogonal zur Ansicht in der die Figur 1 ausgeführt ist, liegt, die Anordnung und Ausbildung eines Massetunnels 3 innerhalb einer Kammer weiter verdeutlicht werden.

Dabei ist auch hier der Massetunnel 3 innerhalb der Kammer angeordnet und besteht ebenfalls aus einem elektrisch leitenden Material, wie beispielsweise Aluminium. Durch die hier obere Kammerwand 11' ist die planare HF/VHF-Elektrode 9 gemeinsam mit der Stromzuführung von einem HF-Generator 12 bis in den Massetunnel 3 geführt und von diesem, wie auch der innerhalb des Massetunnels 3 angeordnete Entladungsraum 6 umschlossen.

Massetunnel 3, HF/VHF-Elektrode 9, wie deren Stromzuführung sind über Isolatoren 13 gegenüberwand der Kammerwand 11' elektrisch isoliert.

Für eine plasmachemische Bearbeitung können Substrate 1 bzw. Substrate 1 gemeinsam mit Substratträgern 2 durch den Massetunnel 3 bewegt werden, was in dieser Darstellung eine Bewegungsrichtung in die Zeichnungsebene hinein bzw. aus der Zeichnungsebene heraus darstellt.

In dieser Darstellung sind weder die Anordnung und Ausbildung der Schlitze 4 und 5 sowie der Prozeßgaszuführung 7 und der Prozeßgasabführung 8 erkennbar, jedoch bei einer entsprechenden Vorrichtung vorhanden. Es wird aber deutlich, dass der Massetunnel 3 gegenüber der Kammer vollständig elektrisch isoliert ist.

Die Stromführung erfolgt über das abgeschirmte Koaxialkabel 15 vom HF/VHF-Generator 12 zur Elektrode 9. Von dort erfolgt sie über das Plasma zwischen Elektrode 9 und Substrat 1, wobei für den elektrischen Widerstand kapazitive Komponenten vernachlässigt werden können.

Im Gegensatz dazu erfolgt die Stromführung von einem Substrat 1 oder einem Substratträger 2 zum Massekanal 3 ausschließlich kapazitiv.

Für die geometrische Kapazität $C_{SM}$, die durch die jeweiligen sich gegenüberliegenden Flächen A von Substrat 1/Substratträger 2 und Massetunnel 3 beeinflusst wird, kann mit

$$C_{SM} = \varepsilon_0 \times \frac{A}{d}$$

berechnet werden, wobei d als Abstand, der freie Spalt in den Schlitzen 4, 5 bei darin eingeführtem Substrat 1 bzw. Substratträger 2 ist.

Durch Einhaltung eines kleinen Abstandes, z.B. $d \le 0,5$ mm kann ein entsprechend reduzierter elektrischer Übergangswiderstand auch bei großen Flächen A erreicht werden.

Der elektrische Widerstand kann mit

$$X_{SM} = \frac{1}{[\omega * C_{SM}]} = \frac{d}{[\omega * \varepsilon_0 * A]}$$

bestimmt werden.

Dabei sind $\omega$ die Wellenlänge der elektrischen Spannung und $\varepsilon_0 = 8,86 \cdot 10^{-12}$ F/m (Dielektrizitätskonstante)

Durch diese Möglichkeit der positiven Beeinflussbarkeit der elektrischen Parameter mit dem kleinen Wert für den Abstand d, wird neben der Reduzierung des elektrischen Widerstandes auch vorteilhaft eine Trennung der atmosphärischen Verhältnisse zwischen dem Inneren des Massetunnels 3 und dessen Umgebung gewährleistet.

Dadurch sind der Innendruck und die Prozeßgaszusammensetzung innerhalb des Massetunnels 3 unabhängig von der Umgebung einstellbar.

Da sowohl die HF-/VHF-Elektrode 9, wie auch der Massetunnel 3 vollständig, unter Vermeidung partieller Massekontakte gegenüber der Kammer und der Umgebung elektrisch isoliert sind, erfolgt die Rückführung des elektrischen Stromes vom Plasma zum HF-/VHF-Generator 12 nahezu vollständig symmetrisch. Eine unerwünschte Beeinflussung des elektrischen Feldes und parasitäre Plasmabildung außerhalb des Bereiches des Entladungsraumes 6 können vermieden werden.

**Patentansprüche**

1. Vorrichtung zur plasmagestützten Bearbeitung von Oberflächen planarer Substrate mittels HF/VHF-Niederdruckgasentladungen, bei der in einer Kammer (11, 11') mindestens eine ebene flächige mit einem Frequenzgenerator (12) elektrisch leitend verbundene Elektrode (9) angeordnet ist, wobei innerhalb der Kammer mindestens ein aus einem elektrisch leitenden Material gebildeter Massetunnel (3) angeordnet ist; innerhalb des Massetunnels (3) die HF/VHF-Elektrode (9) und ein Entladungsraum (6) angeordnet sind, wobei die Oberfläche eines Substrats (1) parallel zur und in einem Abstand zur HF/VHF-Elektrode (9) anordenbar ist, und an den Entladungsraum (6) eine Prozeßgaszuführung (7) und eine Prozeßgasabführung angeschlossen sind, **dadurch gekennzeichnet, dass** der Massetunnel (3) gegenüber der Kammer (11,11') elektrisch isoliert (14) ist, und **dass** der Massetunnel (3) bis auf zwei Schlitze (4, 5) durch die Substrate (1) allein oder gemeinsam mit einem Substratträger (2) in den Massetunnel (3) zur Bearbeitung ein- und im Anschluss an eine Bearbeitung ausführbar sind, allseitig geschlossen ist.

2. Vorrichtung nach Anspruch 1, **dadurch gekennzeichnet, dass** die Kammer eine Vakuumkammer ist.

3. Vorrichtung nach Anspruch 1 oder 2, **dadurch gekennzeichnet, dass** die bei der Bearbeitung innerhalb des Massetunnels (3) die Schlitze (4, 5) teilweise verschließenden Substrate (1) oder Substratträger (2) eine Drosselstelle für eine Gasströmung in den bzw. aus dem Massetunnel (3) bilden.

4. Vorrichtung nach einem der Ansprüche 1 bis 3, **dadurch gekennzeichnet, dass** die bei der Bearbeitung innerhalb des Massetunnels (3) die Schlitze (4, 5) teilweise verschließenden Substrate (1) oder Substratträger (2) mit der Prozeßgaszuführung (7) und der Prozeßgasabführung (8) einen gasdichten Abschluss des Massetunnels (3) gegenüber der Kammer bilden.

5. Vorrichtung nach einem der Ansprüche 1 bis 4, **dadurch gekennzeichnet, dass** die Breite der HF/VHF-Elektrode (9) orthogonal zur Bewegungsrichtung des Substrates (1) gemessen, größer als die entsprechende Breite des Substrates (1) ist.

6. Vorrichtung nach einem der Ansprüche 1 bis 5, **dadurch gekennzeichnet, dass** sie zur Bearbeitung eines Substrats (1) eingerichtet ist, für das die HF/VHF-Elektrode (9) eine kleinere Länge als die Länge der zu bearbeitenden Oberfläche des Substrates (1) aufweist.

7. Vorrichtung nach einem der Ansprüche 1 bis 5, **dadurch gekennzeichnet, dass** die HF/VHF-Elektrode (9) ein elektrisch isoliert und vakuumdicht in die Kammerwand (11') der Kammer einsetzbares Teil ist.

8. Vorrichtung nach einem der Ansprüche 1 bis 7,

**dadurch gekennzeichnet, dass** die Stromzuführung zur HF/VHF-Elektrode (9) als ein Ein- oder Mehrfacheinspeisung orthogonal zur Substratoberfläche ausgebildet ist.

9. Vorrichtung nach einem der Ansprüche 1 bis 8, **dadurch gekennzeichnet, dass** die Ankopplung des elektrischen Stromes zwischen Substrat (1) oder Substratträger (2) mit Substrat (1) und Massetunnel (3) kapazitiv erfolgt.

10. Vorrichtung nach einem der Ansprüche 1 bis 9, **dadurch gekennzeichnet, dass** das Prozeßgas durch den Entladungsraum (6) parallel zur Oberfläche und in Transportrichtung des Substrates (1) geführt ist.

11. Vorrichtung nach einem der Ansprüche 1 bis 10, **dadurch gekennzeichnet, dass** in/am Massetunnel (3) Heizelemente (10) angeordnet sind.

12. Vorrichtung nach einem der Ansprüche 1 bis 11, **dadurch gekennzeichnet, dass** die Schlitze (4, 5) in Transportrichtung des Substrates (1) eine Länge von mindestens 40 mm aufweisen.

13. Vorrichtung nach einem der Ansprüche 1 bis 12, **dadurch gekennzeichnet, dass** die Prozeßgaszuführung (7) als über die gesamte Breite des Massetunnels (3) reichende Gasdusche und die Prozeßgasabführung (8), als über die gesamte Breite des Massetunnels (3) reichende Mehrfachschlitzblende ausgebildet sind.

14. Vorrichtung nach einem der Ansprüche 1 bis 13, **dadurch gekennzeichnet, dass** an den Massetunnel (3) eine einen Unterdruck erzeugende Einrichtung angeschlossen ist.

15. Vorrichtung nach einem der Ansprüche 1 bis 14, **dadurch gekennzeichnet, dass** der Entladungsraum (6) in einem Substratträger (2) oberhalb eines im Substratträger (2) aufgenommenen Substrates (1) ausgebildet ist.

16. Vorrichtung nach einem der Ansprüche 1 bis 14, **dadurch gekennzeichnet, dass** mehrere Massetunnel (3) mit HF/VHF-Elektroden (9) in einer Reihenanordnung in einer Kammer angeordnet sind.

**Claims**

1. Device for the plasma-mediated working of surfaces of planar substrates by means of HF/VHF low-pressure gas discharges, in which at least one planar sheet-like electrode (9), which is connected in an electrically conducting manner to a frequency generator (12), is arranged in a chamber (11, 11'),

   at least one mass tunnel (3) formed from an electrically conducting material being arranged within the chamber;

   the HF/VHF electrode (9) and a discharge space (6) being arranged within the mass tunnel (3), it being possible for the surface of a substrate (1) to be arranged parallel to and at a distance from the HF/VHF electrode (9), and

   a process gas feed (7) and a process gas exhaust being connected to the discharge space (6), **characterized in that** the mass tunnel (3) is electrically insulated with respect to the chamber (11, 11'), and **in that** the mass tunnel (3) is closed on all sides apart from two slots (4, 5) through which substrates (1) alone or together with a substrate support (2) can be introduced into the mass tunnel (3) for working and can be removed following working.

2. Device according to Claim 1, **characterized in that** the chamber is a vacuum chamber.

3. Device according to Claim 1 or 2, **characterized in that** the substrates (1) or substrate supports (2) partially closing the slots (4, 5) during the working within the mass tunnel (3) form a constriction for a gas flow into the and out of the mass tunnel (3).

4. Device according to one of Claims 1 to 3, **characterized in that** the substrates (1) or substrate supports (2) partially closing the slots (4, 5) during the working within the mass tunnel (3) form with the process gas feed (7) and the process gas exhaust (8) a gastight termination of the mass tunnel (3) with respect to the chamber.

5. Device according to one of Claims 1 to 4, **characterized in that** the width of the HF/VHF electrode (9), measured orthogonally in relation to the direction of movement of the substrate (1), is greater than the corresponding width of the substrate (1).

6. Device according to one of Claims 1 to 5, **characterized in that** it is set up for working a substrate (1) for which the HF/VHF electrode (9) has a smaller length than the length of the surface to be worked of the substrate (1).

7. Device according to one of Claims 1 to 5, **characterized in that** the HF/VHF electrode (9) is a part which can be inserted in the chamber wall (11') of the chamber in an electrically insulated and vacuumtight manner.

8. Device according to one of Claims 1 to 7, **characterized in that** the current feed to the HF/VHF electrode (9) is formed as a single or multiple feed orthogonally in relation to the substrate surface.

9. Device according to one of Claims 1 to 8, **characterized in that** the coupling of the electric current between the substrate (1) or the substrate support (2) with the substrate (1) and the mass tunnel (3) is performed capacitively.

10. Device according to one of Claims 1 to 9, **characterized in that** the process gas is conducted through the discharge space (6) parallel to the surface and in the transporting direction of the substrate (1).

11. Device according to one of Claims 1 to 10, **characterized in that** heating elements (10) are arranged in/on the mass tunnel (3).

12. Device according to one of Claims 1 to 11, **characterized in that** the slots (4, 5) have in the transporting direction of the substrate (1) a length of at least 40 mm.

13. Device according to one of Claims 1 to 12, **characterized in that** the process gas feed (7) is formed as a gas spray reaching over the entire width of the mass tunnel (3), and the process gas exhaust (8) is formed as a multiply slotted diaphragm reaching over the entire width of the mass tunnel (3).

14. Device according to one of Claims 1 to 13, **characterized in that** a means of generating a negative pressure is connected to the mass tunnel (3).

15. Device according to one of Claims 1 to 14, **characterized in that** the discharge space (6) is formed in a substrate support (2) above a substrate (1) accommodated in the substrate support (2).

16. Device according to one of Claims 1 to 14, **characterized in that** a number of mass tunnels (3) with HF/VHF electrodes (9) are arranged in series in a chamber.

**Revendications**

1. Dispositif pour le traitement assisté par plasma de surfaces de substrats plans au moyen de décharges gazeuses à basse pression HF/VHF, dans lequel on aménage dans une chambre (11, 11') au moins une électrode (9) de surface plane connectée par conduction électrique à un générateur de fréquence (12), dans lequel :

   au moins un tunnel de masse (3) formé d'un matériau électroconducteur est aménagé dans la chambre; l'électrode HF/VHF (9) et un espace de décharge (6) sont aménagés à l'intérieur du tunnel de masse (3), la surface d'un substrat (1) pouvant être agencée parallèlement à l'électrode HF/VHF (9) et à une certaine distance de cette dernière, et
   une alimentation en gaz de traitement (7) et une évacuation de gaz de traitement sont raccordées à l'espace de décharge (6),

   **caractérisé en ce que** le tunnel de masse (3) est électriquement isolé (14) par rapport à la chambre (11, 11') et **en ce que** le tunnel de masse (3) est fermé de tous côtés à l'exception de deux fentes (4, 5), par lesquelles des substrats (1) peuvent, seuls ou conjointement avec des supports de substrats (2), être introduits dans le tunnel de masse (3) pour traitement et en être évacués à la suite du traitement.

2. Dispositif selon la revendication 1,
   **caractérisé en ce que** la chambre est une chambre à vide.

3. Dispositif selon la revendication 1 ou 2,
   **caractérisé en ce que** les substrats (1) ou les supports de substrats (2) fermant en partie les fentes (4, 5) lors du traitement dans le tunnel de masse (3) forment un point d'étranglement pour un écoulement gazeux entrant dans le tunnel de masse (3) ou en sortant.

4. Dispositif selon l'une quelconque des revendications 1 à 3,
   **caractérisé en ce que** les substrats (1) ou les supports de substrats (2) fermant en partie les fentes (4, 5) lors du traitement dans le tunnel de masse (3) forment, avec l'alimentation en gaz de traitement (7) et l'évacuation de gaz de traitement (8), une fermeture étanche aux gaz du tunnel de masse (3) par rapport à la chambre.

5. Dispositif selon l'une quelconque des revendications 1 à 4,
   **caractérisé en ce** la largeur de l'électrode HF/VHF (9), mesurée orthogonalement à la direction de déplacement du substrat (1), est supérieure à la largeur correspondante du substrat (1).

6. Dispositif selon l'une quelconque des revendications 1 à 5,
   **caractérisé en ce qu'**il est aménagé pour traiter un substrat (1), pour lequel l'électrode HF/VHF (9) présente une longueur plus petite que celle de la surface à traiter du substrat (1).

7. Dispositif selon l'une quelconque des revendications 1 à 5,
   **caractérisé en ce que** l'électrode HF/VHF (9) est une pièce qui peut être insérée de manière électriquement isolée et étanche au vide dans la paroi (11') de la chambre.

**8.** Dispositif selon l'une quelconque des revendications 1 à 7,
**caractérisé en ce que** l'alimentation en courant pour l'électrode HF/VHF (9) se présente orthogonalement à la surface du substrat sous la forme d'une alimentation unique ou multiple.

**9.** Dispositif selon l'une quelconque des revendications 1 à 8,
**caractérisé en ce que** le couplage du courant électrique entre le substrat (1) ou le support de substrat (2) se fait de manière capacitive avec un substrat (1) et un tunnel de masse (3).

**10.** Dispositif selon l'une quelconque des revendications 1 à 9,
**caractérisé en ce que** le gaz de traitement est acheminé à travers l'espace de décharge (6) parallèlement à la surface et dans le sens de transport du substrat (1).

**11.** Dispositif selon l'une quelconque des revendications 1 à 10,
**caractérisé en ce que** des éléments chauffants (10) sont aménagés dans ou sur le tunnel de masse (3).

**12.** Dispositif selon l'une quelconque des revendications 1 à 11,
**caractérisé en ce que** les fentes (4, 5) présentent une longueur d'au moins 40 mm dans la direction de transport du substrat (1).

**13.** Dispositif selon l'une quelconque des revendications 1 à 12,
**caractérisé en ce que** l'alimentation en gaz de traitement (7) se présente sous la forme d'une douche de gaz s'étendant sur toute la largeur du tunnel de masse (3) et l'évacuation de gaz de traitement (8) se présente sous la forme d'un diaphragme à fentes multiples s'étendant sur toute la largeur du tunnel de masse (3).

**14.** Dispositif selon l'une quelconque des revendications 1 à 13,
**caractérisé en ce qu'**un dispositif produisant une dépression est raccordé au tunnel de masse (3).

**15.** Dispositif selon l'une quelconque des revendications 1 à 14,
**caractérisé en ce que** l'espace de décharge (6) est formé dans un support de substrat (2) au-dessus d'un substrat (1) reçu dans le support de substrat (2).

**16.** Dispositif selon l'une quelconque des revendications 1 à 14,
**caractérisé en ce que** l'on aménage plusieurs tunnels de masse (3) avec des électrodes HF/VHF (9) en rangée dans une chambre.

Figur 1

Figur 2